Europäisches Patentamt

European Patent Office

Office européen des brevets

(19)

(11) Veröffentlichungsnummer: **0 264 612 B1**

(12) **EUROPÄISCHE PATENTSCHRIFT**

(45) Veröffentlichungstag der Patentschrift: **11.12.91**

(51) Int. Cl.5: **G01R 15/02, H01F 40/06**

(21) Anmeldenummer: **87113339.3**

(22) Anmeldetag: **11.09.87**

(54) **Stromsensor und Verfahren zum Erfassen des Stromflusses in auszuwertenden Leitern.**

(30) Priorität: **22.09.86 DE 3632117**

(43) Veröffentlichungstag der Anmeldung:
**27.04.88 Patentblatt 88/17**

(45) Bekanntmachung des Hinweises auf die
Patenterteilung:
**11.12.91 Patentblatt 91/50**

(84) Benannte Vertragsstaaten:
**DE FR GB IT**

(56) Entgegenhaltungen:
**DE-A- 1 791 011**

**PATENT ABSTRACTS OF JAPAN, Band 6, Nr.
34 (P-104)[912], 2. März 1982; & JP-A-56 151
361**

**OPTICS LETTERS, Band 6, Nr. 1, Januar 1981,
Seiten 19-21, Optical Society of America,
New York, US; S.C. RASHLEIGH:
"Magnetic-field sensing with a single-mode
fiber"**

**JOURNAL OF PHYSICS E, Band 9, Nr. 6, Juni
1976, Seiten 451-454; R.D. GREENOUGH et al.:
"Strain gauges for the measurement of magnetostriction in the range 4K to 300K"**

(73) Patentinhaber: **SIEMENS AKTIENGESELL-
SCHAFT**
**Wittelsbacherplatz 2**
**W-8000 München 2(DE)**

(72) Erfinder: **Wolf, Johann, Dipl.-Ing.**
**Föhrenweg 20**
**W-8401 Pentling(DE)**

## Beschreibung

Die Erfindung bezieht sich auf einen Stromsensor, der mit einem Ringkörper arbeitet, durch den zumindest ein auszuwertender Leiter hindurchgeführt werden kann und von dem ein Meßsignal abgenommen wird Sowie auf ein Verfahren zum Erfassen des Stromflusses in auszuwertenden Leitern. Derartige Stromsensoren sind üblicherweise als Stromwandler mit Eisenkern oder in Form eines Rogowski-Wandlers ohne Eisen ausgeführt. Derartige Wandler weisen komplizierte Wicklungsformen über einem torusförmigen Rundkörper auf, der in der Herstellung aufwendig und zeitraubend ist.

Ein weiteren Stromsensor ist aus Patent Abstracts of Japan, Band 6, Nr. 34 (P-104) [912], 2. März 1982 bekannt. Dieser Stromsensor arbeitet mit einem Ringkörper, den aus magnetostriktivem Material besteht. Durch den Ringkörper ist der auszuwertende Leiter hindurchgeführt.

Der Erfindung liegt die Aufgabe zugrunde, einen Stromsensor sowie ein Verfahren zum potentialfreien Messen von Strömen und Differenzströmen zu entwickeln, der sich einfach und kostengünstig herstellen läßt.

Die Lösung der geschilderten Aufgabe besteht nach der Erfindung darin, daß auf dem Ringkörper zumindest über einen Ringbereich Leiterbahnen aus längenabhängigem Widerstandsmaterial aufgebracht sind, deren Widerstandsänderung in bekannter Weise ausgewertet und dem zu messenden Strom zugeordnet ist.

Bezüglich des Verfahrens wird die Aufgabe gelöst durch die schnitte gemäß Anspruch 2.

Ein derartiger Stromsensor kommt ohne sonst für die Sekundärwicklung erforderliche aufwendige Durchsteckwindungen aus. Die Primärwicklung kann in üblicher Weise aus einer einfachen oder aus mehrfachen Durchsteckwindungen aufgebaut sein. Obwohl Dehnungsmeßstreifen seit langem bekannt sind, sind diese zum Aufbau eines einfachen jedoch verhältnismäßig genauen Stromsensors noch nicht herangezogen worden.

Es ist günstig, die Leiterbahnen aus längenabhängigem Widerstandsmaterial über den ganzen Umfang des Ringkörpers zu erstrecken, um Längenänderungen entlang des Ringkörpers, wie sie bei großen Fremdfeldern auftreten können, zu eliminieren. Um auch Fremdfeldeinflüsse auf die Leiterbahnen gering zu halten, ist es günstig, die Leiterbahnen als Schleifen aus Hin- und Rückleiter auszubilden. Dadurch werden bifilare Leitungen nachgebildet.

Wenn eine mittige Anzapfung einer Schleife als dritter Anschluß zu den beiden weiteren Anschlüssen der Schleife herausgeführt ist, erzielt man Teilwiderstände, die in Brückenschaltungen benutzt werden können. Es können auch mehrere Schleifen der Leiterbahnen in Reihe geschaltet werden.

Die Erfindung soll nun anhand in der Zeichnung grob schematisch widergegebenen Ausführungsbeispielen näher erläutert werden.

In Fig.1 ist das Prinzip eines Stromsensors in perspektivischer Darstellung veranschaulicht.

In Fig.2 ist ein Ausführungsbeispiel für einen Ringkörper des Stromsensors nach Fig.1 in Aufsicht wiedergegeben.

In Fig.3 ist ein Ringkörper nach Fig.2 mit einer schleifenförmigen Leiterbahn dargestellt.

In Fig.4 ist ein Ringkörper nach Fig.2 mit zwei Schleifen aus Leiterbahnen bei mittiger Anzapfung wiedergegeben.

In Fig.5 ist der Ringkörper nach Fig.4 in Seitenansicht und in Schnittdarstellung veranschaulicht.

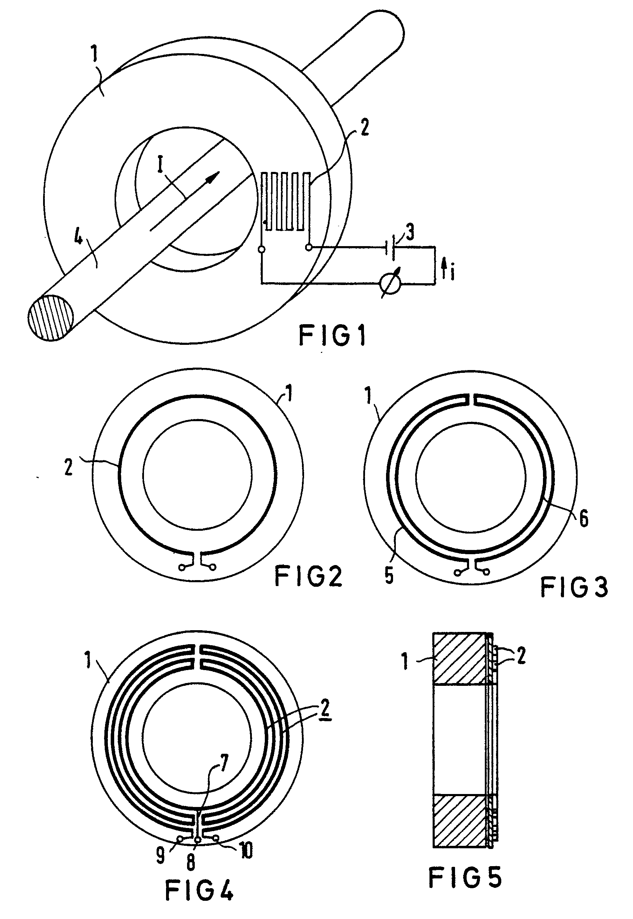

Der Stromsensor nach Fig.1 arbeitet mit einem Ringkörper 1 aus magnetostriktivem Material, auf dem Leiterbahnen 2 aus längenabhängigem Widerstandsmaterial aufgebracht sind. An diese ist eine Spannungsquelle bzw. Meßspannung 3 angelegt, wobei ein Strommesser den zugeordneten Meßstrom i als Maß für den Strom I in einem auszuwertenden Leiter 4 ermittelt.

Auf dem Ringkörper nach Fig.2 ist eine Leiterbahn 2 aus längenabhängigem Widerstandsmaterial über den ganzen Umfang des Ringkörpers angeordnet. Nach Fig.3 bildet die Leiterbahn, die sich über den ganzen Umfang des Ringkörpers erstreckt, eine Schleife aus Hin- und Rückleiter 5,6. Zwei in Reihe angeordnete Schleifen aus Leiterbahnen sind nach Fig.4 mit einer mittigen Anzapfung 7 versehen. Die mittige Anzapfung 7 ist als dritter Anschluß 8 zu den beiden weiteren Anschlüssen 9 und 10 der Schleife herausgeführt.

Der Ringkörper 1 weist im Ausführungsbeispiel, wie aus Fig.5 zu ersehen ist, rechteckigen Querschnitt auf. Die Leiterbahnen 2 sind auf einer Folie angebracht, die am Ringkörper 1 aufgeklebt ist.

Wenn durch den auszuwertenden Leiter 4 nach Fig.1 ein Strom fließt, führen die magnetischen Kräfte im magnetostriktiven Material des Ringkörpers 1 zu einer Änderung seines Umfangs. Diese Umfangsänderung verursacht eine Widerstandsänderungen in den Leiterbahnen 2 aus längenabhängigem Widerstandsmaterial. Dadurch wird bei angelegter Meßspannung 3 im Strommeßgerät ein bestimmter Meßstrom i gemessen. Bei entsprechender Eichung ist jedem auszuwertenden Strom I ein Meßstrom i zugeordnet.

## Patentansprüche

1. Stromsensor, der mit einem Ringkörper (1) arbeitet, durch den zumindest ein auszuwertender Leiter (4) hindurchgeführt werden kann und von dem ein Meßsignal abgenommen wird, wobei der Ringkörper (1) aus magnetostriktivem Material besteht, **dadurch gekennzeichnet,** daß auf dem Ringkörper (1) zumindest über einen Ringbereich Leiterbahnen (2) aus längenabhängigem Widerstandsmaterial aufgebracht sind, deren Widerstandsänderung in bekannter Weise ausgewertet und dem zu messenden Strom (I) zugeordnet ist.

2. Verfahren zum Erfassen des Stromflusses in auszuwertenden Leitern, bei dem der Leiter (4) durch einen Ringkörper (1) aus magnetostriktivem Material geführt wird, **dadurch gekennzeichnet,** daß auf dem Ringkörper (1) zumindest über einen Ringbereich Leiterbahnen (2) aus längenabhängigem Widerstandsmaterial aufgebracht sind, daß an die Leiterbahnen aus längenabhängigem Widerstandsmaterial eine Meßspannung (3) angelegt wird, und daß der zugeorndete Meßstrom (i) als Maß für den Strom (I) im auszuwertenden Leiter (4) dient.

3. Stromsensor nach Anspruch 1, **dadurch gekennzeichnet,** daß sich die Leiterbahnen (2) aus längenabhängigem Widerstandsmaterial über den ganzen Umfang des Ringskörpers (1) erstrecken.

4. Stromsensor nach Anspruch 1, **dadurch gekennzeichnet,** daß die Leiterbahnen (2) aus längenabhängigem Widerstandsmaterial zumindest als Schleifen aus Hin(5) und Rückleiter (6) ausgebildet sind.

5. Stromsensor nach Anspruch 4, **dadurch gekennzeichnet,** daß eine mittige Anzapfung (7) der Schleife als dritter Anschluß (8) zu den beiden weiteren Anschlüssen (9,10) der Schleife herausgeführt ist.

6. Stromsensor nach Anspruch 1, **dadurch gekennzeichnet,** daß der Ringkörper (1) rechteckigen Querschnitt aufweist, auf dem Folien mit Leiterbahnen (2) aufgeklebt sind.

**Claims**

1. Current sensor which operates with an annular body (1) through which at least one conductor (4) that is to be evaluated can be guided and from which a measurement signal is taken, the annular body (1) consisting of magnetostrictive material, characterised in that printed conductors (2) of length-dependent resistance material are applied to the annular body (1) at least over an annular region, the change in resistance of which printed conductors is evaluated in a known manner and is associated with the current (I) to be measured.

2. Method for detecting the current flow in conductors to be evaluated, in which the conductor (4) is guided through an annular body (1) of magnetostrictive material, characterised in that printed conductors (2) of length-dependent resistance material are applied to the annular body (1) at least over an annular region, in that a measuring voltage (3) is applied to the printed conductors of length-dependent resistance material and in that the associated measured current (i) serves as a measure of the current (I) in the conductor (4) to be evaluated.

3. Current sensor according to claim 1, characterised in that the printed conductors (2) of length-dependent resistance material extend over the whole periphery of the annular body (1).

4. Current sensor according to claim 1, characterised in that the printed conductors (2) of length-dependent resistance material are formed at least as loops of forward (5) and return conductors (6).

5. Current sensor according to claim 4, characterised in that a central tap (7) of the loop, serving as a third connection (8), is brought out to the two further connections (9, 10) of the loop.

6. Current sensor according to claim 1, characterised in that the annular body (1) has a rectangular cross section to which foils with printed conductors (2) are affixed.

**Revendications**

1. Détecteur de courant, qui opère avec un corps annulaire (1) à travers lequel peut s'étendre au moins un conducteur (4) à évaluer et au niveau duquel est prélevé un signal de mesure, le corps annulaire (1) étant réalisé en un matériau magnétostrictif, caractérisé par le fait que sur le corps annulaire (1) sont disposées, au moins sur une zone annulaire, des voies conductrices (2) réalisées en un matériau dont la résistance dépend de la longueur, dont la variation de résistance est évaluée de façon connue et est associée au courant (I) à mesurer.

2. Procédé pour détecter le flux de courant dans des conducteurs à évaluer, selon lequel le conducteur (4) traverse un corps annulaire (1) réalisé en un matériau magnétostrictif, caractérisé par le fait que sur le corps annulaire (1) sont disposées, au moins sur une zone annulaire, des voies conductrices (2) formées par un matériau dont la résistance dépend de la longueur, une tension de mesure (3) étant appliquée aux voies conductrices formées du matériau possédant une résistance dépendant de la longueur et que le courant de mesure (i) associé étant utilisé comme mesure du courant (I) dans le conducteur (4) devant être évalué.

3. Détecteur de courant suivant la revendication 1, caractérisé par le fait que les voies conductrices (2) formées par un matériau dont la résistance varie en fonction de la longueur, s'étendent sur toute la circonférence du corps annulaire (1).

4. Détecteur de courant suivant la revendication 1, caractérisé par le fait que les voies conductrices (2) formées d'un matériau, dont la résistance dépend de la longueur, sont réalisées au moins sous la forme de boucles comprenant un conducteur aller (5) et un conducteur retour (6).

5. Détecteur de courant suivant la revendication 4, caractérisé par le fait qu'une prise médiane (7) de la boucle est ressortie, en tant que troisième borne (8), en direction des deux autres bornes (9,10) de la boucle.

6. Détecteur de courant suivant la revendication 1, caractérisé par le fait que le corps annulaire (1) possède une section transversale rectangulaire, sur laquelle sont collée des feuilles pourvues de voies conductrices (2).

FIG 1

FIG 2

FIG 3

FIG 4

FIG 5